# EUROPEAN PATENT APPLICATION

(11) **EP 3 636 590 A1**
(43) Date of publication of application: **15.04.2020**
(21) Application number: 18199227.2
(22) Date of filing: 09.10.2018
(51) Int. Cl.: B82Y 10/00, H01L 29/40, H01L 29/423, H01L 29/49, H01L 29/66, H01L 29/775, H01L 29/06, H01L 21/285

(54) **A METHOD FOR FORMING A SILICIDE GATE FOR A SEMICONDUCTOR DEVICE**

(71) Applicant: IMEC vzw, 3001 Leuven (BE)
(72) Inventor: CHAN, Boon Teik, 3001 Leuven (BE); ALTAMIRANO SANCHEZ, Efrain, 3001 Leuven (BE); DELABIE, Annelies, 3001 Leuven (BE); TOMCZAK, Yoann, 3001 Leuven (BE)
(74) Representative: AWA Sweden AB

(57) **Abstract**

According to an aspect of the present inventive concept there is provided a method for forming a gate (12) for a semiconductor device, the method comprising:
providing a semiconductor structure comprising a substrate (3) and a channel structure (5) protruding above the substrate,
forming a gate dielectric layer (6) on the channel structure,
forming a gate work function metal layer (6) on the gate dielectric layer,
depositing a sacrificial material of silicon (11) to form a preliminary sacrificial gate fill structure, the preliminary sacrificial gate fill structure covering the work function metal and protruding by an initial height above the substrate,
etching back an upper surface of the preliminary sacrificial gate fill structure to obtain a final sacrificial gate fill structure of a reduced height above the substrate, and
converting the sacrificial material of the final sacrificial gate fill structure into a conductive gate fill material (12) by a conversion reaction, thereby forming a silicide gate electrode for the channel structure.

## Description

### Technical field

The present inventive concept relates to a method for forming a gate for a semiconductor device.

### Background

A vertical field effect transistor (VFET) is a field effect transistor where the channel is oriented normal to the substrate. Owing to the vertically oriented channel structure, the gate length is not defined by the linewidth but instead by the thickness of the gate conductor layer. Secondly, the source and drain regions of a vertical transistor device are vertically displaced in relation to each other. For these reasons, among others, vertical transistor devices enable formation a comparably great number of FETs per area unit.

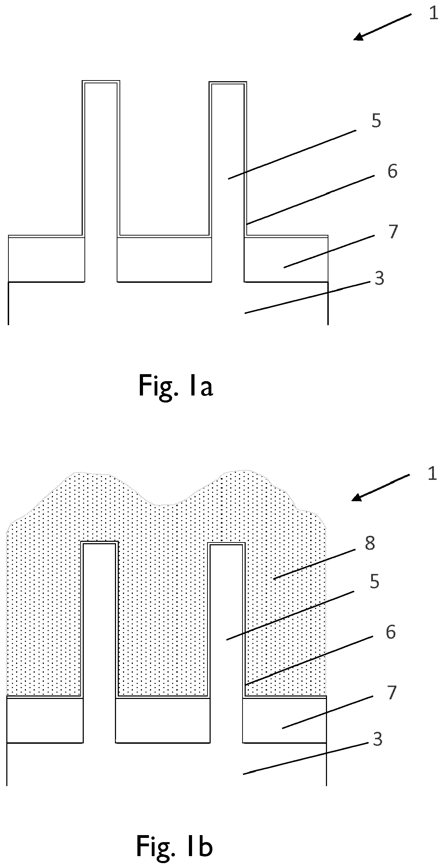

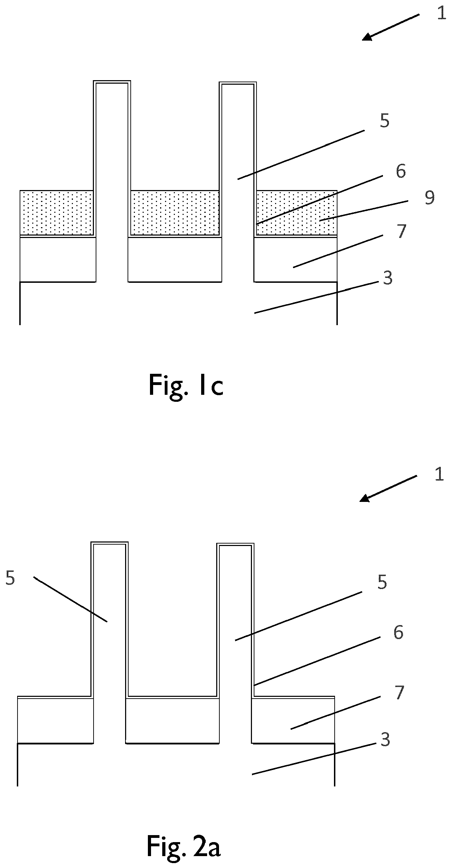

Figures 1a-c schematically depicts a conventional gate formation approach for an intermediate VFET device structure 1. Figure 1a shows a substrate 3 and number of vertical channel structures 5. A lower portion of the channel structures 5 may be embedded in an insulating layer 7. During the gate formation, the vertical channel structures 5 may be covered by a gate dielectric and a work function gate metal, commonly referenced 6. The gate formation may further comprise depositing a conductive gate fill layer 8 such that it covers and surrounds the vertical channels 5. The gate length is then defined by etching back the fill layer 8 to form a reduced thickness conductive material layer 9 only surrounding a portion of each channel 5. Typically, tungsten (W) is used for the fill layer 8, due to its good conductive and filling properties.

A similar tungsten etch back process may be performed during gate formation also for horizontal channel devices, such as gate formation for finFETs. Subsequent to deposition of one or more work function metal layers in the gate trenches, tungsten may be deposited to fill a remaining space in the gate trenches and thereafter etched back to a desired level in the gate trenches.

### Summary

The inventors have realized that the afore-mentioned prior art gate formation approaches involving conductive layer etch back (e.g. a tungsten layer) may result in gate electrodes exhibiting a problematic degree of surface roughness. Surface roughness may render control of the gate length difficult. Surface roughness may further lead to varying thickness and roughness of a subsequently formed isolation layer between the gate and top electrodes. An objective of the present inventive concept is thus to provide a method for forming a gate for a semiconductor device which alleviates or at least reduces the afore-mentioned issue. Further and/or alternative objectives may be understood from the following.

According to an aspect of the present inventive concept there is provided a method for forming a gate for a semiconductor device, the method comprising:
providing a semiconductor structure comprising a substrate and a channel structure protruding above the substrate,
forming a gate dielectric layer on the channel structure,
forming a gate work function metal layer on the gate dielectric layer,
depositing a sacrificial material of silicon to form a preliminary sacrificial gate fill structure, the preliminary sacrificial gate fill structure covering the work function metal and protruding by an initial height above the substrate,
etching back an upper surface of the preliminary sacrificial gate fill structure to obtain a final sacrificial gate fill structure of a reduced height above the substrate, and
replacing the sacrificial material of the final sacrificial gate fill structure with a conductive gate fill material by a conversion reaction, thereby forming a gate electrode for the channel structure.

By the inventive method a gate electrode for a semiconductor device may be formed with a smooth upper surface. This is enabled by a combination of etch back of the silicon preliminary sacrificial gate fill structure and a conversion of the final sacrificial gate structure into a conductive gate fill structure.

The surface roughness which may result following etch back of a gate fill layer (as in the prior art) may be attributed to the considerable grain sizes of conductive materials typically used for gate fill (notably W). Etch back of silicon, in particular amorphous silicon or polysilicon, does not result in a same degree of surface roughness. Hence, etch back of the silicon preliminary sacrificial gate fill structure allows forming of a final sacrificial gate structure having a smooth upper surface. The conversion reaction may then result in atoms of the final sacrificial gate structure being replaced by atoms of the conductive gate fill material. Thereby a conductive gate fill structure with a correspondingly smooth upper surface may be obtained. Meanwhile, the presence of the gate dielectric layer and the work function metal on the channel structure may counteract etching of the channel structure during the etch back.

The preliminary sacrificial gate may be formed to embed at least a channel region of the channel structure, at least partially. The final gate electrode may thus surround the channel region of the channel structure. This in turn allows for the gate electrode to be provide good electrostatic control.

The method may further comprise forming an insulating layer on the substrate (i.e. an upper surface thereof) prior to forming the gate dielectric layer and the gate work function metal layer.

By this the gate electrode may be isolated from the substrate by an insulating layer, which may form a bottom dielectric layer. Also the insulating layer may provide a further masking of the substrate may be from process conditions during the sacrificial material deposition and the conversion reaction.

The gate dielectric layer and the work function metal layer may be deposited on the channel structure and on an upper surface of the insulating layer. Hence, the gate dielectric layer and the work function metal layer may be deposited to cover both the channel structure and the upper surface of the insulating layer. The gate dielectric layer and the gate work function metal layer may be formed to cover at least a channel region of the channel structure.

The method may further comprise planarizing the deposited sacrificial material to form the preliminary sacrificial gate fill structure with a planarized upper surface prior to the etch back thereof. This may facilitate obtaining a final sacrificial gate fill structure with uniform height / thickness following the etch back.

Replacing the sacrificial material of the final sacrificial gate fill structure with a conductive gate fill material may comprise completely replacing the sacrificial material of the final sacrificial gate fill structure.

The gate electrode may hence be formed with no traces of the sacrificial material remaining in the conductive fill gate structure. In other words, the final sacrificial gate fill structure may be fully replaced by/converted into the conductive gate fill structure.

The sacrificial material may comprise amorphous silicon (a-Si) or polysilicon. These materials may be deposited free of pin-holes in an inexpensive and efficient manner using conventional deposition techniques, such as chemical vapor deposition (CVD).

The conductive material may comprise tungsten or molybdenum. Silicon materials (such as a-Si and polysilicon) may be readily converted into either tungsten or molybdenum by means of conversion reactions. Moreover, tungsten and molybdenum both enable forming of a gate electrode with good electrical properties.

Replacing the sacrificial material with the conductive material may comprise exposing the sacrificial material to a tungsten fluoride gas (such as tungsten hexafluoride) or a molybdenum fluoride gas. The sacrificial material may thus react with the tungsten fluoride gas and be replaced with tungsten. Alternatively, the sacrificial material may react with the molybdenum fluoride gas and be replaced with molybdenum.

The inventive method is applicable to gate formation for both vertical and horizontal channel devices. A vertical channel device may be a vertical field effect transistor (VFET) with a gate-all-around (GAA) configuration, i.e. a gate electrode completely enclosing the vertical channel structure in a circumferential direction. A horizontal channel device may be a finFET (e.g. with a tri-gate configuration) or a horizontal nanowire FET (NW-FET) with a GAA configuration.

Embodiments where the channel structure is vertically oriented, allow forming of a semiconductor device with a vertical channel, such as a vertical field effect transistor, with a gate electrode having a smooth upper surface.

The sacrificial material may be deposited to completely cover a vertically oriented channel structure. The gate length may thereafter be defined by etching back the preliminary sacrificial gate fill structure to a desired level along the vertical channel structure.

The preliminary sacrificial gate fill structure may be etched back such that the channel structure protrudes above the final sacrificial gate fill structure.

Thus, the final sacrificial gate fill structure (and correspondingly also the conductive gate fill structure) may be defined to extend along a vertical section of the channel structure. A portion of the channel structure protruding above the sacrificial gate electrode fill structure may facilitate subsequent source/drain region and source/drain electrode formation.

The method may further comprise, subsequent to replacing the sacrificial material, removing the gate dielectric layer and the work function metal layer from the portion of the channel structure protruding above the final sacrificial gate fill structure. The portion of the channel structure above the final sacrificial gate fill structure may hence be exposed for subsequent processing, such as source/drain region and source/drain electrode formation.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1a-c schematically illustrates a conventional gate formation approach for a VFET.
Figures 2a-e schematically illustrate a method for forming a gate for a semiconductor device having a vertically oriented channel structure.
Figure 3 schematically illustrates a method for forming a gate for a semiconductor device having a horizontally oriented channel structure.

### Detailed description

A method for forming a gate for a semiconductor device will now be disclosed with reference to Figures 2a through 2e. It should be noted that, owing to the schematic nature of the drawings, the relative dimensions of the various structures and layers are not drawn to scale. Rather the dimensions have been adapted for illustrational clarity and to facilitate understanding of the following description.

At the stage of the method shown in Figure 2a a semiconductor structure 1 has been provided. The semiconductor structure 1 comprises a substrate 3. The substrate may be semiconductor substrate of a conventional type, such as an Si substrate. Other examples may be a Ge substrate, a SiGe substrate, a SiC substrate, a SOI substrate, a GeOI substrate or a SiGeOI substrate.

The semiconductor structure 1 comprises a channel structure 5. The channel structure 5 protrudes above the substrate 3. The channel structure 5 is vertically oriented, i.e. extends parallel to a normal direction of the substrate 3. Reference will in the following be made to a single channel structure 5, however as can be seen in the figure the semiconductor structure 1 may comprise a number of similar channel structures 5. The channel structures 5 may be arranged in a regular array along the substrate 3, e.g. comprising a plurality of rows and columns.

The channel structure 5 may be made of one or more semiconductor materials, for instance Si, SiGe or Ge. As is known in the art, each one of the channel structures 5 may be formed on a doped bottom electrode region of the substrate 3, such that a lower source/drain region may be formed underneath each channel structure 5. The channel structures 5 may be formed in a conventional manner, for instance by patterning one or more epitaxial semiconductor layers formed on the substrate 3. As a few non-limiting examples, the channel structures 5 may be patterned in Si-layer, a SiGe-layer or a Ge-layer, or in a stack of layers such as a SiGe/Si/SiGe layer stack or a SiGe/Ge/SiGe layer stack. The present method is applicable to junction less devices as well as inversion mode devices and the layer(s) may be doped accordingly. The channel structures 5 may be patterned to present, for instance, a circular, oval or rectangular cross-sectional shape and thus form a pillar or nanowire-like structure. Patterning of the channel structures 5 may comprise defining a patterned mask, such as a hard mask (e.g. of Si₃N₄, spin-on-carbon or a carbon-based patterning film), an oxide-based mask or a photoresist mask, on the one or more epitaxial semiconductor layers and etching the one or more epitaxial semiconductor layers while using the patterned mask as an etch mask. As shown in Figure 2a, the mask may be removed subsequent to the channel patterning. However, it is also possible to keep the mask portions of the patterned mask on top of the patterned channel structures until upper source/drain processing subsequent to gate formation.

An insulating layer 7 has been formed on the substrate 1. The insulating layer 7 covers an upper surface of the substrate 3, more specifically the bottom electrode region(s) of the substrate 3. The insulating layer 7 surrounds a lower part of the channel structure 5. More specifically, the insulating layer 7 may completely wrap around the lower part of the channel structure 5. The insulating layer 7 may be formed by depositing an insulating material to cover an upper surface of the substrate 1 and the channel structures 5. Following planarization (e.g. by CMP) of the deposited insulating material, etch back may be performed to form the insulating layer 7 with a desired thickness. The insulating layer 7 may be formed by a CVD deposited dielectric material, for instance silicon nitride, Si₃N₄ or an oxide material such as SiO₂, SiCo, SiON or SiOCN.

Subsequent to forming the insulating layer 7, a stack of a conformal gate dielectric layer and a work function metal (WFM) layer, commonly referenced layer 6, may be formed on the channel structure 5. The gate dielectric layer may be formed by one or more layers of a conventional gate dielectric material such as SiO₂ or HfOx, or any other suitable high-k gate dielectric material. As can be seen in the figure the gate dielectric layer may be deposited to cover the sidewalls of the channel structure 5. The gate dielectric layer may further cover an upper surface of the channel structure 5 (or the mask portion if remaining following channel structure patterning). The gate dielectric layer may be deposited to cover also the insulating layer 7. The gate dielectric layer may be deposited by atomic layer deposition (ALD).

The work function metal layer may be formed to completely cover the the gate dielectric layer. The work function metal layer may be formed by an effective work function metal (EWF). Depending on the conductivity type of the vertical channel device which is to be formed, the conductive layer may for instance be formed by one or more p-type EWF metals such as TiN, TaN, TiTaN or by one or more n-type EWF metals such as Al, TiAl, TiC, or TiAIC, or compound layers such as TiN/TiAl or TiN/TaN/TiAI. The WFM layer may be deposited as a conformal layer, for instance by ALD.

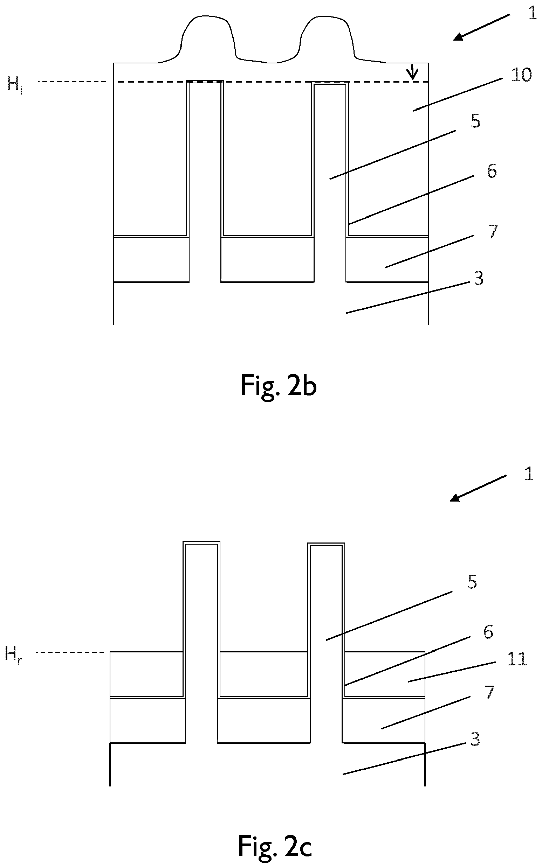

At the stage of the method shown in Figure 2b a sacrificial material has been deposited on the semiconductor structure 1. The deposited sacrificial material completely covers the channel structure 5. As schematically indicated in Figure 2b, the deposited sacrificial may be planarized, e.g. by CMP, to form a preliminary sacrificial gate fill structure 10 having a planar upper surface. The upper surface of the preliminary sacrificial gate fill structure 10 may be flush, at least substantially, with the layer portion 6 covering the upper surface of the channel structure 5. The planarization may be stopped when the layer portion 6 covering the upper surface of the channel structure 5 is exposed. Alternatively, if the mask portion from the channel structure patterning remains on the channel structure 5, the upper surface of the preliminary sacrificial gate fill structure 10 may be flush, at least substantially, with an upper surface of the mask portion. In this case, the planarization may be stopped when the upper surface of the mask portion is exposed. The preliminary fill structure 10 embeds and wraps around the channel structure 5. The preliminary fill structure 10 protrudes by an initial height Hᵢ above the substrate 3. The preliminary sacrificial structure 10 covers the gate dielectric and WFM layer stack 6. The preliminary fill structure 10 completely embeds the channel region of the channel structure 5. The sacrificial material may be amorphous silicon. Alternatively, the sacrificial material may be polycrystalline silicon. The sacrificial material may be deposited by CVD or sputtering.

At the stage of the method shown in Figure 2c the preliminary sacrificial gate fill structure 10 has been etched back to form a final sacrificial gate fill structure 11. The channel structure 5 protrudes above the final sacrificial gate fill structure 11. The preliminary sacrificial gate fill structure 10 has been etched back such that the final sacrificial gate fill structure 11 is of a reduced height Hᵣ above the substrate 3. For instance, an isotropic dry etch process may be used for the etch back, such as a reactive ion etch (RIE) using a fluorine based etchant, such as SF₆.

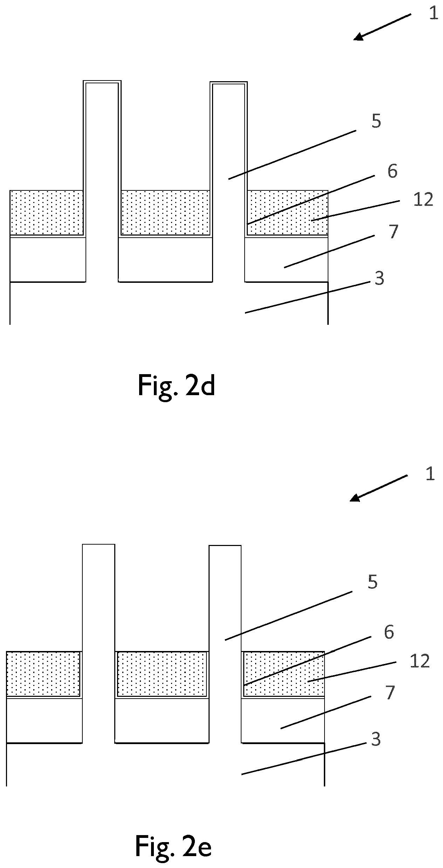

At the stage of the method shown in Figure 2d the sacrificial material of the final sacrificial gate fill structure 11 has been replaced with a conductive gate fill material, thereby forming a conductive gate fill structure 12 wrapping around the channel structure 5. The conductive gate fill structure 12 and the WFM layer may together form a final wrap-around gate electrode for the channel structure 5. The sacrificial material has been replaced by a conversion reaction. The conversion reaction replaces the sacrificial material of the final sacrificial gate fill structure 11 with the conductive gate fill material by replacing the atoms of the sacrificial material with atoms of the conductive gate fill material. The conversion reaction may be performed such that the sacrificial material of the final sacrificial gate fill structure 11 is completely replaced by the conductive gate fill material.

The conversion reaction may comprise exposing the sacrificial material of the final sacrificial gate fill structure 11 to a reactive gas comprising the conductive gate fill material as a component. The reactive gas may be tungsten hexafluoride, WF₆. Thereby, a W gate fill structure may be formed through the conversion reaction 2WF₆ + 3Si --> 2W + 3SiF₄. The reactive gas may be supplied to a reactor chamber in which the structure 1 is arranged. Additional gases may be supplied into the reactor chamber, such as an (inert) carrier gas, for example argon or nitrogen gas. The conversion reaction may be performed at a temperature in the range of about 300 to 450 °C (ambient temperature of the reactor chamber). A pressure may be around 1 torr. Also other conversion reactions are possible, for instance using molybdenum fluoride, MFₓ, as the reactive gas. Thereby, a Mo gate fill structure may be formed through a corresponding conversion reaction where Si of the sacrificial material acts as a reductant.

In any case, the conversion reaction may be performed under a sufficiently long time for the sacrificial material of the final sacrificial gate fill structure 13 to be completely replaced by the conductive gate fill material.

At the stage of the method shown in Figure 2e the gate dielectric layer and the work function metal layer 6 has been removed from the portion of the channel structure 5 protruding above the gate fill structure 12. That is, from regions of the channel structure 5 above the final sacrificial gate fill structure 12. The gate dielectric layer and the work function metal layer 6 may be removed in an etch process for etching the gate dielectric layer and the work function metal layer 6 selectively to the tungsten and the material of the channel structure 5. For instance an isotropic etch process comprising a BCl₃/Cl₂ etching chemistry may be used.

The method may thereafter proceed by depositing a further insulating layer (e.g. of SiO₂ or some other low-k dielectric) embedding the gate electrode(s) and the (previously) exposed protruding portion of the channel structure(s). The method may thereafter proceed by forming upper source/drain regions, source/drain electrodes and contact formation, using techniques which per se are known in the art.

In the above, the method has been described in the context of a gate first process, i.e. gate formation prior to top source/drain and electrode formation. However, the method is also compatible with a gate last / replacement metal gate (RMG) process. As is known to the skilled person, in a conventional RMG process, an a-Si or polysilicon dummy gate may be removed from a gate trench after top source/drain and electrode formation. One or more gate metals may thereafter be deposited in the trench, including a tungsten gate fill metal, which subsequently may be etched back to a desired height/thickness. As described above this etch back may result in surface roughness. The inventive method may instead be implemented in the RMG-process by substituting the conventional tungsten fill deposition and etch back (after dummy gate removal) by: forming a preliminary sacrificial gate fill structure of the sacrificial silicon material in the gate trench, etching back the preliminary sacrificial gate fill structure to a desired height and thereafter performing the conversion reaction to form the conductive gate fill structure in the gate trench.

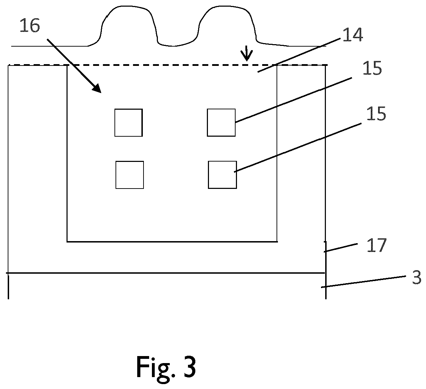

In Figures 2a through 2e the method has been realized for a semiconductor structure comprising vertically oriented channel structures. It is however also possible to realize the method for a semiconductor structure where the channel structure is horizontally oriented. A structure comprising a number (i.e. one or more) of horizontally oriented channel structures 15 is shown in Figure 3. The illustrated channel structures 15 are in the form of horizontal nanowires, however fin-shaped semiconductor structures are also possible. The structure is shown in a cross-section taken perpendicular to the horizontal direction of the channel structures 15, at a position within a gate trench 16. The gate trench 16 may be formed by removing a dummy gate embedded in an insulating layer 17. A sacrificial material, for instance of a-Si or polysilicon, has been deposited in the gate trench 16 to embed the portions of the channel structures 15 extending through the gate trench 16, thus extending across the horizontal direction of the channel structures. The deposition of the sacrificial material may be preceded with deposition of a gate dielectric layer and WFM layer on the channel structures. As schematically indicated in Figure 3, the deposited sacrificial may be planarized, e.g. by CMP, to form a preliminary sacrificial gate fill structure 14 having a planar upper surface. The preliminary sacrificial gate fill structure 14 may subsequently be etched back to form a final sacrificial gate fill structure of a desired reduced height within the gate trench 16. The final sacrificial gate fill structure may be subjected to a conversion reaction, as disclosed above, to form a conductive gate fill structure, e.g. of W or Mo. The conductive gate fill structure and the WFM layer may together form a final wrap-around gate electrode for the one or more channel structures 15.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a gate for a semiconductor device, the method comprising:
providing a semiconductor structure comprising a substrate and a channel structure protruding above the substrate,
forming a gate dielectric layer on the channel structure,
forming a gate work function metal layer on the gate dielectric layer,
depositing a sacrificial material of silicon to form a preliminary sacrificial gate fill structure, the preliminary sacrificial gate fill structure covering the work function metal and protruding by an initial height above the substrate,
etching back an upper surface of the preliminary sacrificial gate fill structure to obtain a final sacrificial gate fill structure of a reduced height above the substrate, and
replacing the sacrificial material of the final sacrificial gate fill structure with a conductive gate fill material by a conversion reaction, thereby forming a gate electrode for the channel structure.

2. A method according to claim 1, wherein the preliminary sacrificial gate is formed to embed at least a channel region of the channel structure.

3. A method according to any preceding claim, further comprising forming an insulating layer on the substrate prior to forming the gate dielectric layer and the gate work function metal layer.

4. A method according to claim 3, wherein the gate dielectric layer and the work function metal layer is deposited on the channel structure and on an upper surface of the insulating layer.

5. A method according to any preceding claim, further comprising planarizing the deposited sacrificial material to form the preliminary sacrificial gate fill structure with a planarized upper surface prior to the etch back thereof.

6. A method according to any preceding claim, wherein replacing the sacrificial material of the final sacrificial gate fill structure with a conductive gate fill material completely replaces the sacrificial material of the final sacrificial gate fill structure.

7. A method according to any preceding claim, wherein the sacrificial material comprises amorphous silicon or polysilicon.

8. A method according to any preceding claim, wherein the conductive material comprises tungsten or molybdenum.

9. A method according to any preceding claim, wherein replacing the sacrificial material with the conductive material comprises exposing the sacrificial material to a tungsten fluoride gas or a molybdenum fluoride gas.

10. A method according to any preceding claim, wherein the channel structure is vertically oriented.

11. A method according to claim 10, wherein the sacrificial material is deposited to completely cover the channel structure.

12. A method according to any of claims 10 and 11, wherein the preliminary sacrificial gate fill structure is etched back such that the channel structure protrudes above the final sacrificial gate fill structure.

13. A method according to any of claims 11 to 12, further comprising, subsequent to replacing the sacrificial material, removing the gate dielectric layer and the work function metal layer from the portion of the channel structure protruding above the final sacrificial gate fill structure.

14. A method according to any of claims 1 to 9, wherein the channel structure is horizontally oriented.
